# EUROPÄISCHE PATENTSCHRIFT

(11) **EP 4 480 010 B1**
(45) Veröffentlichungstag und Bekanntmachung des Hinweises auf die Patenterteilung: **10.09.2025**
(21) Anmeldenummer: 23701407.1
(22) Anmeldetag: 19.01.2023
(51) Int. Cl.: H10F 10/19, H10F 77/70, H10K 30/40, H10K 30/57, H10K 30/87

(54) **ERZEUGUNG TEXTURIERTER OBERFLÄCHEN, HERSTELLUNG VON TANDEMSOLARZELLEN UND TANDEMSOLARZELLE**
PRODUCING TEXTURED SURFACES, MANUFACTURING TANDEM SOLAR CELLS, AND TANDEM SOLAR CELLS
PRODUCTION DE SURFACES TEXTURÉES, FABRICATION DE CELLULES SOLAIRES EN TANDEM ET CELLULES SOLAIRES EN TANDEM

(30) Priorität: 18.02.2022 DE 102022201714
(43) Veröffentlichungstag der Anmeldung: 25.12.2024
(73) Patentinhaber: Singulus Technologies AG, 63796 Kahl am Main (DE)
(72) Erfinder: NOACK, Philipp, 82216 Maisach (DE); WATTENBERG, Bianca, 82239 Alling (DE); CORDA, Mirza, 82216 Maisach (DE); MANDLMEIER, Benjamin, 82343 Pöcking (DE)
(74) Vertreter: Stöckeler, Ferdinand
(86) Internationale Anmeldenummer: PCT/EP2023/051247
(87) Internationale Veröffentlichungsnummer: WO 2023/156123

(56) Entgegenhaltungen:
- EP-A1- 3 633 736
- EP-A1- 3 840 060
- WO-A1-2020/228904
- FENGYOU WANG ET AL: "Pyramidal texturing of silicon surface via inorganic?organic hybrid alkaline liquor for heterojunction solar cells", JOURNAL OF POWER SOURCES, vol. 293, 9 June 2015 (2015-06-09), AMSTERDAM, NL, pages 698 - 705, XP055639847, ISSN: 0378-7753, DOI: 10.1016/j.jpowsour.2015.05.124
- PAPET P ET AL: "Pyramidal texturing of silicon solar cell with TMAH chemical anisotropic etching", SOLAR ENERGY MATERIALS AND SOLAR CELLS, ELSEVIER SCIENCE PUBLISHERS, AMSTERDAM, NL, vol. 90, no. 15, 22 September 2006 (2006-09-22), pages 2319 - 2328, XP028002384, ISSN: 0927-0248, [retrieved on 20060922], DOI: 10.1016/J.SOLMAT.2006.03.005

## Beschreibung

Die vorliegende Erfindung betrifft Verfahren zum Erzeugen einer texturierten Oberfläche einer Halbleiterschicht, Verfahren zum Herstellen von Tandemsolarzellen mit einer solchen texturierten Oberfläche und durch solche Verfahren hergestellte Tandemsolarzellen.

Bei Solarzellen wird die Oberfläche von Halbleiterwafern, insbesondere Siliziumwafern, in der Regel texturiert, um den Reflexionsgrad zu verringern und damit die Lichtausbeute zu erhöhen. Um eine solche Texturierung zu erreichen, ist es bekannt, die Waferoberfläche anisotrop unter Verwendung einer alkalischen Ätzlösung zu ätzen, die ein Additiv aufweist, so dass Pyramiden in die Oberfläche geätzt werden. Als Additiv wird dabei Isopropanol oder ein isopropanolfreies Additiv verwendet, um das Silizium derart abzutragen, dass die Oberfläche mit Pyramiden ausgebildet wird.

Es sind mehrschichtige Solarzellen bekannt, bei denen mehrere verschiedene halbleitenden Elemente/Verbindungen übereinander angeordnet sind, um unterschiedliche Bandlücken der verschiedenen halbleitenden Elemente/Verbindungen auszunutzen. Damit einhergeht eine unterschiedlich starke Absorption bestimmter Wellenlängenbereiche des Sonnenlichts. Solche mehrschichtigen Solarzellen sind auch als Tandemsolarzellen bekannt. Untere Solarzellenstrukturen, sogenannte Bottomzellen, sollen vor allem langwellige Bereiche des Lichts absorbieren, während obere Solarzellenstrukturen, sogenannte Topzellen, die höhere Zellschichten darstellen, kurzwellige Anteile des Lichts in elektrische Energie umwandeln sollen. Unter einer Solarzellenstruktur kann dabei hierin eine Struktur verstanden werden, die in der Lage ist, einfallendes Licht in elektrische Ladungsträger umzuwandeln, die dann zumindest teilweise extrahiert werden können. Durch die selektive Absorption der einzelnen Schichten kann das Sonnenlicht insgesamt besser ausgenutzt und in elektrische Energie umgewandelt werden als bei einfachen Solarzellen. Dies macht sich durch höhere Effizienzen der Tandemsolarzelle im Vergleich zu einfachen Solarzellen bemerkbar. Tandemsolarzellen können auch mehr als zwei übereinander angeordnete Solarzellenstrukturen aufweisen.

Als Material für die unterste Solarzellenstruktur, d.h. die Bottomzelle, eignet sich c-Si, also kristallines Silizium, monokristallin oder polykristallin. Als Material für obere Solarzellenstrukturen (Topzellen) bzw. nächst höhere Solarzellschichten über der untersten Solarzellenstruktur (Bottomzelle) eignet sich unter anderem Perowskit. Dabei wird das Perowskit auf der unteren Solarzellenstruktur abgeschieden. Es sind verschiedene Verfahren zum Abscheiden von Perowskitschichten bekannt, zu denen Lösungs-basierte Abscheideprozesse und Dampf-basierte Abscheideprozesse zählen. Beispiele gängiger Verfahren eines Lösungs-basierten Abscheidens von Perowskitschichten sind das Spin-Coating und das Slot-Die-Coating. Ein Beispiel eines üblichen Dampf-basierten Abscheideverfahrens ist das Co-Verdampfen.

Bei Dampf-basierten Abscheideverfahren handelt es sich um Prozesse, die auf einer physikalischen Dampfabscheidung (PVD), einer chemischen Dampfabscheidung (CVD) oder einer Atomlagenabscheidung (ALD) basieren, die in aller Regel ein Hochvakuum erfordern. Hierbei werden die Edukte des Perowskits, beispielsweise durch thermisches Erhitzen, in die Gasphase überführt, wobei sie an der Oberfläche des Substrats, bei dem es sich um eine c-Si-Bottomzelle handeln kann, zum Perowskit reagieren und aufwachsen. Vorteile dieser Dampf-basierten Verfahren liegen in der homogenen Abscheidung der Schicht und einer präzise einstellbaren Schichtdicke des Perowskits. Weiterhin stellt diese Beschichtungsmethode keine Ansprüche an die Oberflächenmorphologie der Oberfläche, auf der die Abscheidung stattfindet, da die Perowskitschicht sich sowohl auf glatten als auch auf texturierten Oberflächen gleichermaßen gut abscheiden lässt. Nachteile dieser Dampf-basierten Verfahren sind hingegen einerseits eine erschwerte Kontrolle des stöchiometrischen Verhältnisses der zu verdampfenden Edukte und die damit einhergehende anspruchsvolle Prozesskontrolle und andererseits die technisch aufwändigen Bedingungen im Hochvakuum. Weiterhin muss nach erfolgter Abscheidung ein Anneal-Schritt (eine Temperung) erfolgen, um die gewünschte Kristallinität des Perowskits zu erzeugen. Dieser Schritt wirkt sich neben der limitierten Abscheiderate ebenfalls durchsatzlimitierend in Hinsicht auf die kommerzielle Umsetzung aus. Generell können Dampf-basierte Abscheideverfahren verglichen mit Lösungs-basierten Abscheideverfahren hinsichtlich der Investitionsausgaben und des Durchsatzes nachteilig sein.

Bei Lösungs-basierten Abscheideverfahren werden die Edukte des Perowskits als Gemisch (Mix) in flüssiger Form direkt auf die Oberfläche der Bottomzelle aufgebracht, wobei die aufgebrachte Lösung anschließend unter Normaldruck und geringen Temperaturen, beispielsweise kleiner als 120 °C, trocknet und sich das Perowskit ausbildet. Generell kann die Abscheidung vollständig oder teilweise Lösungs-basiert sein. Es gibt z.B. Hybridverfahren, bei denen eine Komponente Lösungsbasiert aufgebracht wird und eine weitere Komponente mittels Verdampfung aus der Gasphase abgeschieden wird. Die Vorteile derartiger Lösungs-basierter Verfahren sind technisch einfach umsetzbare Prozessbedingungen, welche sich positiv auf die Kosten auswirken und ferner die Realisierung hoher Durchsätze ermöglichen. Ferner lassen sich durch die einfache Steuerung der Edukt-Zusammensetzung zudem Optimierungen schnell umsetzen. Nachteilig an Lösungs-basierten Abscheideverfahren kann neben der Handhabung der Edukt-Lösungen, die teils toxisch sein können, vor allem die Herausforderung der Erzeugung einer homogenen Schichtdicke sein, was sich mit steigender Substratgröße zunehmend erschwert. Weiterhin kann die Homogenität der Schichtdicke stark von der Oberflächenmorphologie der Oberfläche, auf der abgeschieden wird, abhängen, da die Schicht nicht wie bei den Dampf-basierten Verfahren als homogene Schicht aufwächst, sondern als Film abgeschieden wird, der morphologische Ungleichmäßigkeiten nicht zwingend ausgleichen kann.

Um eine hohe Lichtabsorption zu erzielen, welche zu einem höheren Wirkungsgrad und somit höheren Zelleffizienzen führt, ist es üblich, auch die Tandemsolarzelle mit einer Textur zu versehen, welche üblicherweise auf der unteren Solarzellenstruktur, beispielsweise der c-Si-Bottomzelle, gebildet wird. Eine solche Textur kann wiederum zum Großteil nasschemisch durch anisotropes Ätzen mittels Alkalimetallhydroxid-Lösungen, die Additive enthalten, erfolgen, so dass Pyramiden-förmige Texturen erzeugt werden.

Aus der US 2009/0 280 597 A1 ist ein Glättungsverfahren für eine Texturoberfläche bekannt, bei dem Kanten von pyramidenförmigen Texturen unter Verwendung eines alkalischen Ätzbads abgerundet oder geglättet werden, wobei jedoch der Materialabtrag so gering sein soll, dass das Reflexionsmaß der texturierten Oberfläche nicht beeinträchtigt wird. Aus der US 2018/0 158 976 A1 und der US 2021/0126147 A1 sind Tandemsolarzellen bekannt, die eine Kombination einer Perowskit-Solarzelle mit einer Siliziumsolarzelle aufweisen. FENGYOU WANG et al., "Pyramidal texturing of silicon surface via inorganicorganic hybrid alkaline liquor for heterojunction solar cells", JOURNAL OF POWER SOURCES, Bd. 293, Seiten 698-705, offenbart ein Verfahren zum Erzeugen einer texturierten Oberfläche einer Halbleiterschicht.

EP 3 840 060 A1 offenbart eine Tandemsolarzelle.

### Beschreibung der Erfindung

Die Aufgabe der vorliegenden Erfindung besteht darin, Verfahren zum Erzeugen einer texturierten Oberfläche einer Halbleiterschicht zu schaffen, die Texturen aufweist, die zum Aufbringen weiterer Schichten geeignet sind. Eine weitere Aufgabe der vorliegenden Erfindung besteht darin, ein Verfahren zum Herstellen einer Tandemsolarzelle, die eine solche texturierte Oberfläche aufweist, und eine entsprechende Tandemsolarzelle zu schaffen.

Diese Aufgabe wird durch ein Verfahren zum Erzeugen einer texturierten Oberfläche gemäß Anspruch 1, ein Verfahren zum Herstellen einer Tandemsolarzelle nach Anspruch 11 und eine Tandemsolarzelle gemäß Anspruch 14 gelöst.

Ausführungsbeispiele der Erfindung schaffen ein Verfahren zum Erzeugen einer texturierten Oberfläche einer Halbleiterschicht, mit folgenden Merkmalen: anisotropes Ätzen einer Oberfläche einer Halbleiterschicht mit einer ersten alkalischen Ätzlösung, um eine Oberfläche der Halbleiterschicht, die pyramidenförmige Texturen aufweist, zu erzeugen; und anisotropes Ätzen der Oberfläche, die die pyramidenförmigen Texturen aufweist, mit einer zweiten alkalischen Ätzlösung, die von der ersten alkalischen Ätzlösung verschiedenen ist, um einen Materialabtrag der pyramidenförmigen Texturen zu bewirken, durch den eine Höhendifferenz zwischen Gipfeln und benachbarten Tälern der pyramidenförmigen Texturen reduziert wird.

Beispiele der vorliegenden Erfindung basieren auf der Erkenntnis, dass es durch die Verwendung einer zweiten alkalischen Ätzlösung, die sich von der ersten alkalischen Ätzlösung unterscheidet, möglich ist, die Höhe der unter Verwendung der ersten alkalischen Ätzlösung erzeugten pyramidenförmigen Texturen zu verringern. Dies wird hierin auch als alkalischer Pyramiden-Cut bezeichnet. Dadurch kann die texturierte Oberfläche geeignet insbesondere für ein Lösungs-basiertes Aufbringen nachfolgender Schichten gemacht werden. Gleichzeitig bleiben jedoch Texturen bestehen, die einen ausreichend geringen Reflexionsgrad bewirken, um die Halbleiterschicht effizient als Solarzelle einsetzen zu können.

Beispiele der vorliegenden Erfindung schaffen ein Verfahren zum Herstellen einer Tandemsolarzelle, das neben einem entsprechenden Erzeugen einer texturierten Oberfläche einer Halbleiterschicht das Erzeugen einer ersten Solarzellenstruktur der Tandemsolarzelle, die die texturierte Oberfläche aufweist, und das Erzeugen einer zweiten Solarzellenstruktur der Tandemsolarzelle auf der Seite der ersten Solarzellenstruktur, auf der die texturierte Oberfläche angeordnet ist, aufweist. Solche Beispiele ermöglichen es, zur Erzeugung der zweiten Solarzellenstruktur eine Perowskitschicht Lösungs-basiert aufzubringen, da aufgrund der verringerten Höhe der Texturen vermieden werden kann, dass pyramidenförmige Strukturen nach dem Aufbringen aus der Perowskitschicht ragen und somit Kurzschlüsse verursachen können.

Erfindungsgemäß erfolgt nach einer anisotropen Texturierung im alkalischen Milieu eine Nachbehandlung der pyramidenförmigen Texturen (Pyramiden-Cut) anisotrop im alkalischen Milieu, was die Reduzierung der Höhe der pyramidenförmigen Texturen durch eine alkalische, nicht toxische Ätzlösung bei reduzierten Betriebskosten ermöglicht.

Bei Beispielen erfolgt die Nachbehandlung, d.h. das anisotrope Ätzen mit der zweiten alkalischen Ätzlösung derart, dass die Höhendifferenz zwischen Gipfeln und benachbarten Tälern von zumindest einigen der pyramidenförmigen Texturen um mindestens 5 %, mindestens 10 % oder mindestens 20 % reduziert wird. Bei Beispielen liegt die Höhe der erzeugten pyramidenförmigen Strukturen vor der Nachbehandlung in einem Bereich von 1 µm bis 3 µm. Entsprechend kann durch die Nachbehandlung ein Materialabtrag erfolgen, der eine Reduzierung der Höhe von mindestens 50 nm, mindestens 100 nm oder mindestens 200 nm im Fall einer Pyramidenhöhe von 1 µm, von mindestens 100 nm, mindestens 200 nm oder mindestens 400 nm im Fall einer Pyramidenhöhe von 2 µm, und von mindestens 150 nm, mindestens 300 nm, oder mindestens 600 nm im Fall einer Pyramidenhöhe von 3 µm zur Folge hat. Bei Beispielen kann durch den Pyramiden-Cut somit ein Materialabtrag (und somit eine Reduzierung der Höhe) zumindest einiger der pyramidenförmigen Texturen um zumindest 50 nm in einer Richtung senkrecht zu einer Ebene der Halbleiterschicht erfolgen. Bei Beispielen kann dadurch die gesamtheitliche Pyramidenstruktur in der Höhe egalisiert werden, indem insbesondere die Höhe von pyramidenförmigen Texturen, die weiter von der Ebene vorstehen als andere, durch den Materialabtrag reduziert wird.

Bei Beispielen wird durch das Ätzen mit dem zweiten Ätzmittel ein Winkel zwischen Pyramidenflächen von zumindest einigen der pyramidenförmigen Texturen und einer Ebene der Halbleiterschicht reduziert. Bei Beispielen werden Pyramidenspitzen von zumindest einigen der pyramidenförmigen Texturen abgetragen. Die entsprechenden Änderungen der Form der Texturen kann ohne Weiteres durch entsprechende Bildaufnahmen oder Vermessungen verifiziert werden, dass sich die durch das erfindungsgemäße Verfahren erzeugte texturierte Oberfläche oder Tandemsolarzellen von mit üblichen Verfahren erzeugten Tandemsolarzellen unterscheiden. Beispiele der vorliegenden Offenbarung beziehen sich auf eine entsprechend hergestellte Tandemsolarzelle, bei der die texturierte Oberfläche der Halbleiterschicht Texturen aufweist, die durch die hierein beschriebene Nachbehandlung durch den Abtrag von Spitzen der pyramidenförmigen Texturen erhalten wurden und entsprechend abgetragene Pyramidenspitzen in Form eines Plateaus oder Winkel zwischen einer Pyramidenfläche und einer Ebene der Halbleiterschicht von 50° oder weniger aufweisen.

Beispiele der vorliegenden Offenbarung schaffen eine Tandemsolarzelle, die nach einem der hierin beschriebenen Verfahren hergestellt ist, mit folgenden Merkmalen: einer ersten Solarzellenstruktur, die eine Halbleiterschicht mit einer texturierten Oberfläche aufweist; und eine zweite Solarzellenstruktur auf der Seite der ersten Solarzellenstruktur, auf der die texturierte Oberfläche angeordnet ist, wobei die texturierte Oberfläche der Halbleiterschicht Texturen aufweist, die ein Plateau aufweisen, das durch den Abtrag von Spitzen der pyramidenförmigen Texturen gebildet ist, so dass eine Höhendifferenz zwischen Gipfeln und benachbarten Tälern der pyramidenförmigen Texturen verglichen mit entsprechenden Texturen ohne abgetragene Spitzen um mindestens 5%, bevorzugt um mindestens 10% reduziert ist, und/oder Texturen aufweist, bei denen ein Winkel zwischen einer Pyramidenfläche von zumindest einigen der pyramidenförmigen Texturen und einer Ebene der Halbleiterschicht 50° oder weniger beträgt, so dass die Höhendifferenz zwischen Gipfeln und benachbarten Tälern der pyramidenförmigen Texturen verglichen mit entsprechenden Texturen, bei denen ein Winkel zwischen einer Pyramidenfläche und einer Ebene der Halbleiterschicht etwa 55° beträgt, um mindestens 5%, bevorzugt um mindestens 10% reduziert ist. Unter entsprechenden pyramidenförmigen Texturen sind dabei solche zu verstehen, die eine gleiche Grundfläche aufweisen.

Bei Beispielen weist ein Reflexionsgrad der texturierten Oberfläche nach dem Ätzen der zweiten Ätzlösung 10 bis 20 % für Licht einer Welle von 600 nm auf. Somit kann entsprechendes Licht mit dieser oder einer längeren Wellenlänge effektiv in die erste Solarzellenstruktur eindringen. Somit kann ein guter Wirkungsgrad beibehalten werden.

Bei Beispielen ist die zweite alkalische Ätzlösung eine Alkalimetalllösung. Somit ermöglichen Beispiele die Erzeugung entsprechender Texturen verringerter Höhe unter Verwendung von nicht toxischen Ätzlösungen im alkalischen Milieu. Bei anderen Beispielen ist die zweite alkalische Ätzlösung eine TMAH-Ätzlösung. Bei Beispielen weist die Halbleiterschicht kristallines Silizium, c-Si, auf. Bei Beispielen weist die zweite Solarzellenstruktur Perowskit auf. Beispiele der vorliegenden Offenbarung ermöglichen somit die Erzeugung von Tandemsolarzellen unter Verwendung gut bekannter Materialien, die eine effektive Absorption von Licht bei den jeweiligen Wellenlängen ermöglichen.

Bei Beispielen weist die erste alkalische Ätzlösung ein Additiv auf, durch das die pyramidenförmigen Texturen erzeugt werden, wobei die zweite alkalische Ätzlösung dieses Additiv nicht aufweist, so dass durch die Nachbehandlung ein anisotroper Abtrag von Material von den pyramidenförmigen Texturen erfolgt, durch den die Morphologie der pyramidenförmigen Texturen verändert wird, um die Höhe derselben zu verringern.

Bei Beispielen wird das anisotrope Ätzen der texturierten Oberfläche unter zumindest einer und vorzugsweise allen folgenden Prozessbedingungen durchgeführt: Alkalimetallhydroxidkonzentration: 0,01 - 40 Gewichtsprozent; Temperatur: 15 - 90 °C, bevorzugt 20 - 80°C, besonders bevorzugt 20 - 65 °C; Ätzdauer: 3 - 300 s, bevorzugt 30 - 300 s, besonders bevorzugt 30 - 180 s; pH-Bereich: 7 - 14, bevorzugt 9 - 14. Die Ätzrate und der gesamte Ätzabtrag und somit die Reduzierung der Höhe der pyramidenförmigen Texturen ist von diesen Parametern abhängig, so dass ein optimiertes Zusammenspiel zwischen nötigem Abtrag für die Strukturausbildung und wirtschaftlichen Prozesszeiten erhalten werden kann.

Bei Beispielen weist das Verfahren vor dem anisotropen Ätzen mit dem ersten Ätzmittel ein alkalisches Ätzen mit einem dritten Ätzmittel zum Entfernen von Sägeschäden von der Halbleiterschicht auf. Beispiele ermöglichen somit die Vorbereitung einer Oberfläche der unteren Solarzellenstruktur für das Aufbringen der oberen Solarzellenstruktur unter Verwendung von alkalischen Mitteln. Bei Beispielen findet nach dem Ätzen mit dem zweiten Ätzmittel eine nasschemische Reinigung der texturierten Oberfläche statt, um diese für weitere Prozessschritte vorzubereiten.

Bei Beispielen weist das Erzeugen der ersten Solarzellenstruktur das Erzeugen eines pn-Übergangs in oder auf der Halbleiterschicht auf und weist das Erzeugen der zweiten Solarzellenstruktur das Erzeugen eines pn-Übergangs auf, wobei zwischen der ersten und der zweiten Solarzellenstruktur eine leitfähige Schicht, eine elektrische Kontaktierung und/oder ein elektrische Isolierung erzeugt wird. Bei Beispielen erfolgt die Erzeugung des pn-Übergangs der ersten Solarzellenstruktur durch Dotierung, beispielsweise mittels Gasphasenabscheidung oder Diffusion. Bei Beispielen weist die Erzeugung des pn-Übergangs der zweiten Solarzellenstruktur ein Aufbringen entsprechend dotierter Schichten auf. Unter einem pn-Übergang wird hierin sowohl ein direkter pn-Übergang als auch ein indirekter Übergang mit beispielsweise einer intrinsischen Schicht dazwischen verstanden.

Bei Beispielen weist das Erzeugen der zweiten Solarzellenstruktur das Aufbringen einer Perowskit-Schicht mittels eines zumindest teilweise Lösungs-basierten Verfahrens auf. Dadurch können die eingangs beschriebenen Vorteile erreicht werden. Das Verfahren kann zu 100 % lösungsbasiert sein. Alternativ können auch Hybridverfahren verwendet werden, bei denen eine Komponente des Perowskits lösungsbasiert aufgebracht wird, wobei eine weitere Komponente mittels Verdampfung aus der Gasphase abgeschieden wird. Bei Beispielen weist das Erzeugen der zweiten Solarzellenstruktur das Erzeugen einer Perovskit-Absorbtionsschicht zwischen einer Elektronentransportschicht und einer Löchertransportschicht auf. Im Betrieb absorbiert die Perovskitschicht Licht, was die Erzeugung freier Elektronen und Löcher zur Folge hat.

Bei Beispielen weist das Verfahren ein Einstellen des durch das Ätzen mit dem zweiten Ätzmittel bewirkten Abtrags auf, durch zumindest entweder: Einstellen einer Hydroxid-Konzentration in dem zweiten Ätzmittel, wobei bei einer Hydroxid-Konzentration bis 15 Gewichtsprozent die Ätzrate mit zunehmender Hydroxid-Konzentration zunimmt, bei einer Hydroxid-Konzentration von 15 bis 25 Gewichtsprozent die Ätzrate maximal ist und bei einer Hydroxid-Konzentration über 25 Gewichtsprozent die Ätzrate mit zunehmender Hydroxid-Konzentration abnimmt; Einstellen der Temperatur, wobei mit steigender Temperatur die Ätzrate zunimmt; oder Einstellen der Ätzdauer, wobei mit steigender Ätzdauer der Gesamtätzabtrag zunimmt. Somit kann durch Einstellen eines oder mehrerer der genannten Parameter in einer für praktische Anwendungen annehmbaren Prozesszeit ein Abtrag der pyramidenförmigen Texturen bewirkt werden, der auf der einen Seite ausreicht, um Kurzschlüsse zu vermeiden, und auf der anderen Seite einen ausreichend geringen Reflexionsgrad von beispielsweise 10,0 bis 25,0 % bei einer Wällenlänge von 600 nm ermöglicht.

### Kurze Beschreibung der Zeichnungen

Beispiele der vorliegenden Offenbarung werden nachfolgend bezugnehmend auf die beiliegenden Zeichnung näher erläutert. Es zeigen:
- Fig. 1: rein schematisch eine Querschnittdarstellung einer Tandemsolarzelle;
- Fig. 2 und 3: schematische Darstellungen von Beispielen von Tandemsolarzellen zur Erläuterung eines Kurzschlusses durch eine obere Solarzellenstruktur;
- Fig. 4: ein Flussdiagramm eines Beispiels eines erfindungsgemäßen Verfahrens zum Herstellen einer Tandemsolarzelle;
- Fig. 5: ein Flussdiagramm eines Beispiels eines Verfahrens zur Bearbeitung der Oberfläche einer Halbleiterschicht bei der Herstellung einer Tandemsolarzelle;

- Fig. 6a-6e: schematische Querschnittdarstellungen zur Erläuterung eines Beispiels eines erfindungsgemäßen Verfahrens;
- Fig. 7a-7d: schematische Querschnittdarstellungen zur Erläuterung, wie bei Beispielen der vorliegenden Erfindung ein Materialabtrag der pyramidenförmigen Texturen stattfindet; und

### Detaillierte Beschreibung

Im Folgenden werden Beispiele der vorliegenden Offenbarung detailliert und unter Verwendung der beigefügten Zeichnungen beschrieben. Es sei darauf hingewiesen, dass gleiche Elemente oder Elemente, die die gleiche Funktionalität aufweisen, mit gleichen oder ähnlichen Bezugszeichen versehen sind, wobei eine wiederholte Beschreibung von Elementen, die mit dem gleichen oder ähnlichen Bezugszeichen versehen sind, typischerweise weggelassen wird. Beschreibungen von Elementen, die gleiche oder ähnliche Bezugszeichen aufweisen, sind gegeneinander austauschbar. In der folgenden Beschreibung werden viele Details beschrieben, um eine gründlichere Erklärung von Beispielen der Offenbarung zu liefern. Es ist jedoch für Fachleute offensichtlich, dass andere Beispiele ohne diese spezifischen Details implementiert werden können. Merkmale der unterschiedlich beschriebenen Beispiele können miteinander kombiniert werden, es sei denn Merkmale einer entsprechenden Kombination schließen sich gegenseitig aus oder eine solche Kombination ist ausdrücklich ausgeschlossen.

Im folgenden werden Beispiele der Erfindung insbesondere im Zusammenhang mit der Herstellung von Tandemsolarzellen beschrieben, bei der eine texturierte Oberfläche einer c-Si-Schicht erzeugt wird, auf die dann eine Perowskit-Schicht, insbesondere Lösungs-basiert, aufgebracht wird. Es sei jedoch darauf hingewiesen, dass die Halbleiterschicht statt c-Si auch andere Materialien aufweisen kann, wie z.B. Germanium oder Galliumarsenid. Ferner sei darauf hingewiesen, dass es sich anstatt einer Perowskit-Schicht auch um eine Schicht aus einem anderen amorphen oder mikroskristallinen Absorbermaterial, das kurzwellige Anteile des Lichts absorbieren kann, handeln kann. Bei Beispielen werden auf die texturierte Oberfläche weitere Schichten aufgebracht, um eine Tandemsolarzelle zu schaffen, bei der auf effektive und kostengünstige Weise Kurzschlüsse durch eine obere Solarzellenstruktur vermieden werden können.

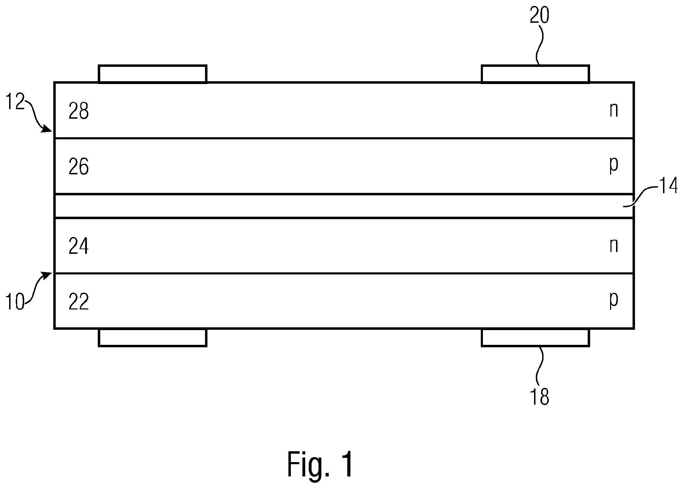

Fig. 1 zeigt rein schematisch ein Beispiel eines Tandemsolarzellkonzepts, auf das Beispiele der vorliegenden Offenbarung anwendbar sind. Fig. 1 zeigt einen Querschnitt einer Tandemsolarzelle mit einer unteren Solarzellenstruktur 10, die üblicherweise auch als Bottomzelle bezeichnet wird, und einer oberen Solarzellenstruktur 12, die üblicherweise auch als Topzelle bezeichnet wird. Bei Beispielen ist die untere Solarzellenstruktur 10 eine Solarzelle auf der Basis von kristallinem Silizium (c-Si). Bei Beispielen ist die obere Solarzellenstruktur 12, die über der unteren Solarzellenstruktur 10 angeordnet ist, eine Perowskit-Solarzelle, die beispielsweise mittels Dampf-basierter oder Lösungs-basierter Beschichtungs- oder Abscheideverfahren aufgebracht ist, wie es oben beschrieben ist. Bei weiteren Beispielen können unterhalb und/oder oberhalb der Solarzellenstrukturen 10, 12 weitere Solarzellenstrukturen (nicht gezeigt) angeordnet sein. Die untere Solarzellenstruktur 10 weist eine Löchertransportschicht 22, die p-dotiert ist, und eine Elektronentransportschicht 24, die n-dotiert ist, auf. Die obere Solarzellenstruktur 12 weist eine Löchertransportschicht 26, die p-dotiert ist, und eine Elektronentransportschicht 28, die n-dotiert ist, auf. Zwischen den Solarzellenstrukturen 10 und 12 ist in der Regel eine Rekombinationsschicht 14 angeordnet, die leitfähig ist. Auf der Unterseite der unteren Solarzellenstruktur 10 sind erste Anschlusselektroden 18 und auf der Oberseite der oberen Solarzellenstruktur 12 sind zweite Anschlusselektroden 20 gebildet. Dieses Tandemsolarzellenkonzept ist rein beispielhaft, wobei beispielsweise die Anordnung der einzelnen Schichten (n und p) auch vertauscht sein kann, und wobei beispielsweise auf eine Rekombinationsschicht verzichtet sein kann und stattdessen die Topzelle und Bottomzelle separat und beidseitig kontaktiert sind.

Bei einer solchen Tandemsolarzelle erzeugen die Solarzellenstrukturen jeweils Elektronen-Loch-Paare unabhängig voneinander, wobei die Extraktion von Löchern von den Anschlusselektroden 18 der Bottomzelle 10 und die Extraktion von Elektronen durch die Anschlusselektroden 20 von der Topzelle 12 erfolgt. Der Rest der erzeugten Ladungsträger, Elektronen von der Bottomzelle 10 und Löcher von der Topzelle 12, können innerhalb der Tandemsolarzelle über die Rekombinationsschicht 14 rekombinieren. Die Rekombinationsschicht 14 ist normalerweise sehr dünn und transparent, so dass sie nicht viel Licht absorbiert und ist leitfähig, so dass sie die Rekombination ermöglicht. Die Rekombinationsschicht kann z.B. eine oder mehrere Schichten aus Indiumzinnoxid, ITO, aufweisen. Alternativ können statt der Rekombinationsschicht voneinander isolierte leitfähige Schichten zwischen der unteren Solarzellenstruktur 10 und der oberen Solarzellenstruktur 12 vorgesehen sein. Diese voneinander isolierten leitfähigen Schichten können mit externen Anschlüssen versehen sein, um die von der unteren Solarzellenstruktur 10 erzeugten Elektronen zu extrahieren und die von der oberen Solarzellenstruktur 12 erzeugten Löcher zu extrahieren. An dieser Stelle sei angemerkt, dass die Anordnung der jeweiligen Elektronentransportschichten und Löchertransportschichten beispielhaft ist und diese auch vertauscht sein kann.

Wie es oben beschrieben ist, wird, um eine hohe Lichtabsorption zu erzielen, die untere Solarzellenstruktur üblicherweise mit einer Textur versehen. Eine solche Textur kann wiederum zum Großteil nasschemisch durch anisotropes Ätzen mittels Alkalimetallhydroxid-Lösungen, die Additive enthalten, erfolgen, so dass Pyramiden-förmige Texturen erzeugt werden. Die Höhe (Abmessung senkrecht zur Hauptebene der Halbleiterschicht) der einzelnen Pyramiden der Texturen kann über die Prozessbedingungen gesteuert werden und kann bei Beispielen eine Höhe von weniger als 3 µm betragen.

Perowskitschichten können je nach Prozess und gewünschtem Aufbau der Tandemsolarzelle mit unterschiedlichen Dicken zwischen 20 nm und 1000 nm oder darüber aufgebracht werden. Lösungs-basierte Perowskite können typischerweise eine Dicke von ca. 500 nm besitzen. Dies hat zur Folge, dass eine Kombination von texturierten Bottomzellen und Perowskit-Topzellen, die mittels Lösungs-basierten Methoden erzeugt werden, bisher nur schwer realisierbar ist, da die Pyramidenspitzen der unteren Solarzellenstruktur durch die Perowskitschicht ragen und elektrische Kurzschlüsse (Shunts) erzeugen können.

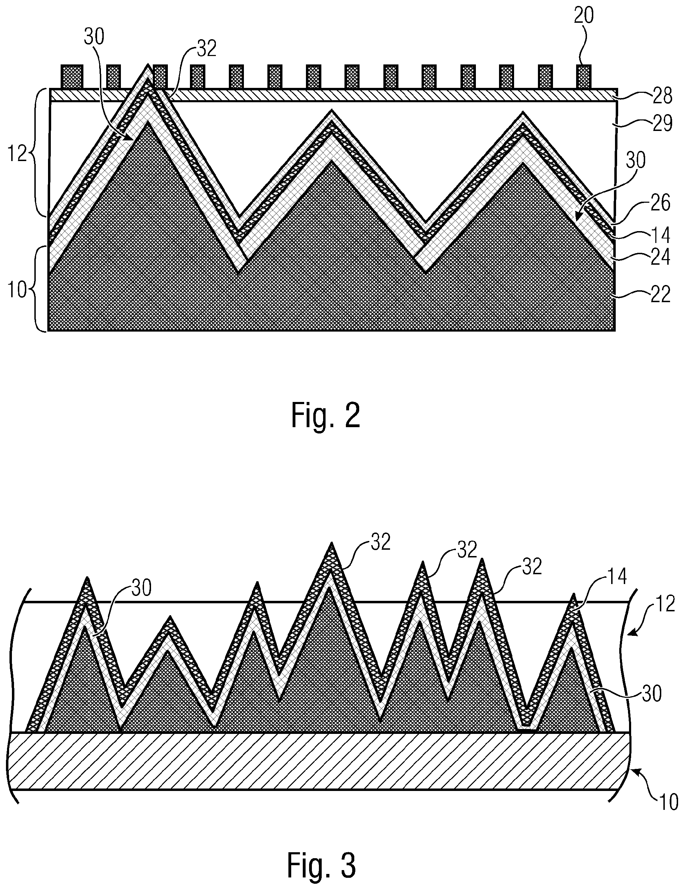

Fig. 2 zeigt eine schematische Querschnittdarstellung einer Tandemsolarzelle mit einer unteren c-Si-Bottomzelle und einer Perowskit-Topzelle 12. Auf der Oberseite der Bottomzelle 10 sind pyramidenförmige Texturen 30 gebildet. Die Topzelle 12 kann mittels Lösungs-basierter Methoden auf die c-Si-Bottomzelle aufgebracht sein, nachdem eine Rekombinationsschicht 14 auf der Bottomzelle 10 erzeugt wurde. Die Bottomzelle 10 weist wiederum eine Löchertransportschicht 22 und eine Elektronentransportschicht 24 auf. Die Topzelle 12 weist eine Löchertransportschicht 26, eine Elektronentransportschicht 28 und eine Elektronen-Loch-Erzeugungsschicht 29 (beispielsweise Perovskit) auf. Die Elektronentransportschicht 24 kann beispielsweise aus C60 bestehen und die Löchertransportschicht kann beispielsweise aus Spiro-OMeTAD bestehen. Die Reihenfolge dieser Schichten kann wiederum vertauscht sein.

Wie in Fig. 2 gezeigt ist, weist eine der pyramidenförmigen Texturen 30 eine solche Höhe auf, dass sie durch die obere Solarzellenstruktur 12 ragt und einen Kurzschluss 32 mit auf der Oberfläche der oberen Solarzellenstruktur 12 angeordneten Anschlusselektroden bzw. Metallkontakten 20 erzeugt. Die Höhe der pyramidenförmigen Texturen kann nach dem Erzeugen derselben durch das anisotropes Ätzen variieren, wie in Fig. 3 gezeigt ist. Fig. 3 zeigt eine ebenfalls rein schematische Querschnittdarstellung der Tandemsolarzelle von Fig. 2, wobei mehrere pyramidenförmige Texturen 30 der Bottomzelle 10 durch die Topzelle 12 ragen und entsprechende Kurzschlüsse 32 bilden.

Die oben bezugnehmend auf die Fig. 2 und 3 erläuterte Problematik könnte gelöst werden, indem keine Textur oder eine Textur von sehr kleinen Pyramiden abhängig von der Dicke der Perowskitschicht, beispielsweise < 1 µm, verwendet wird. Eine weitere Möglichkeit könnte darin bestehen, eine lichtdurchlässige Schicht über dem Perowskit abzuscheiden, die texturiert ist, wobei die Schicht zwischen Bottomzelle und Perowskit untexturiert bleibt. Diese Möglichkeiten sind jedoch mit einer Reihe von Nachteilen verbunden, die schließlich zu einem Effizienzverlust der Tandemsolarzelle führen. Eine weitere Möglichkeit bestünde in der Nachbehandlung der texturierten Oberfläche mittels HF/Ozon, was zu einer Verrundung der Pyramidenspitzen führen würde. Diese ist jedoch zu gering, so dass die Spitzen weiterhin durch die Perowskitschicht ragen würden. Diesbezüglich wurden Verfahren beschrieben, bei denen sowohl Pyramidenspitzen als auch Pyramidentäler abgerundet werden, wobei auch ein Winkel der Pyramidenseitenflächen zur Substratoberfläche auf einem Betrag von geringfügig weniger als 55° reduziert wird, so dass die Pyramidenhöhe bei gleichbleibender Grundfläche reduziert wird. Dies geschieht durch ausschließlich isotrope Ätzprozesse, die nasschemisch mittels HF/HNO₃, durch reaktives Ionenätzen, Gasphasen-Ätzen oder Sputter-Ätzen durchgeführt werden können. Dieses bekannte Verfahren wird bei Verfahren angewendet, bei denen Perowskit Dampf-basiert abgeschieden wird, wobei der Gibbs-Thompson-Effekt umgegangen werden soll und sich somit homogenere Schichten ausbilden sollen.

Beispiele der Erfindung richten sich auf Verfahren zum Erzeugen einer texturierten Oberfläche einer Halbleiterschicht und Verfahren zum Herstellen von Tandemsolarzellen, die geeignet sind, um die angesprochenen Kurzschlussprobleme zu verhindern. Dazu werden die pyramidenförmigen Texturen nach der Erzeugung derselben einer Nachbehandlung, die hierin auch als Pyramiden-Cut bezeichnet wird, unterzogen.

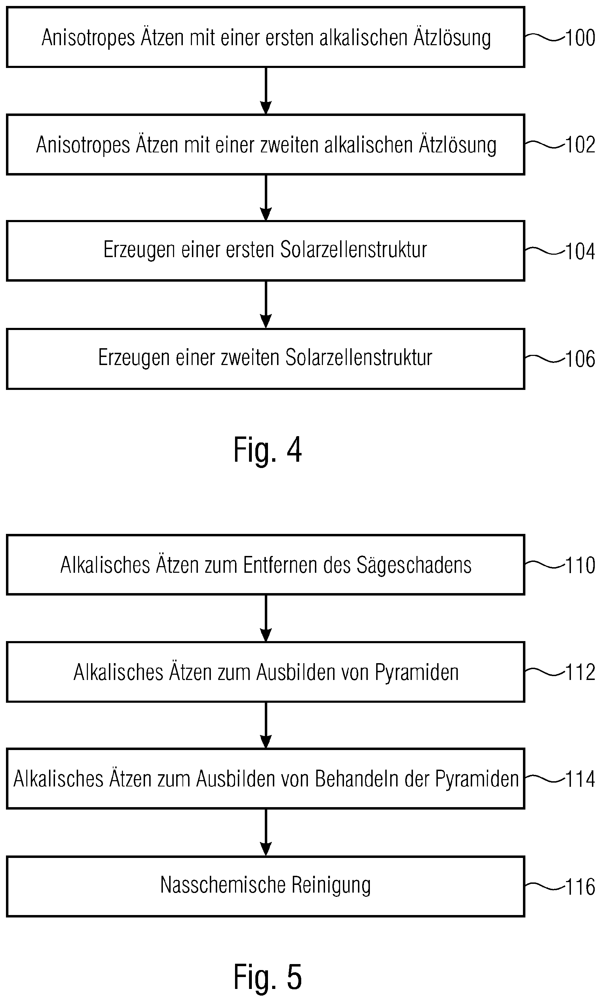

Wie bei 100 in Fig. 4 gezeigt ist, findet zum Erzeugen der texturierten Oberfläche zunächst ein anisotropes Ätzen mit einer ersten alkalischen Ätzlösung statt, bei dem pyramidenförmige Texturen auf einer Halbleiterschicht, beispielsweise einer c-Si-Bottomzelle, anisotrop erzeugt werden. Die pyramidenförmigen Strukturen können eine Höhe von < 3 µm aufweisen. Als erste alkalische Ätzlösung kann beispielsweise eine Alkalimetalllösung, die ein Additiv enthält, verwendet werden. Als erste alkalische Ätzlösung kann jegliche bekannte alkalische Ätzlösung verwendet werden, die geeignet ist, entsprechende pyramidenförmige Texturen auf der Halbleiteroberfläche zu erzeugen. In einem nächsten Schritt 102 erfolgt dann ebenfalls anisotrop mittels einer zweiten alkalischen Ätzlösung eine Nachbehandlung, durch die ein Materialabtrag der pyramidenförmigen Texturen bewirkt wird. Als zweite alkalische Ätzlösung können Alkalimetalllösungen verwendet werden, sozusagen als Polituransatz. Die zweite alkalische Ätzlösung weist keine Additive auf, die die Erzeugung pyramidenförmiger Strukturen bewirken würde. Beispielsweise kann die Zusammensetzung der zweiten alkalischen Ätzlösung im Wesentlichen der der ersten alkalischen Ätzlösung ohne das entsprechende Additiv entsprechen. Bei Beispielen ergeben sich durch die Nachbehandlung mit der zweiten alkalischen Ätzlösung eine oder mehrere der folgenden Änderungen der Morphologie der Pyramiden: die Spitzen der Pyramiden werden entfernt, die Spitzen der Pyramiden werden geglättet, der Winkel der Pyramiden wird verändert, es bilden sich Plateaus aus. Kernpunkt der Erfindung ist somit die anisotrope Nachbehandlung im alkalischen Milieu nach der anisotropen Textur im alkalischen Milieu. Die durch die anisotrope Nachbehandlung erzeugten morphologischen Veränderungen werden hierein auch als Pyramiden-Cut bezeichnet. Durch den Pyramiden-Cut können zum einen ähnliche Lichtabsorptionseigenschaften erzielt werden wie bei gewöhnlich texturierten Oberflächen und zum anderen kann das Perowskit mittels Lösungs-basierter Techniken abgeschieden werden, da die entfernten/geglätteten Spitzen nicht mehr durch das Perowskit ragen und sich demzufolge keine Kurzschlüsse mehr ausbilden.

Bei Beispielen der Erfindung wird nach dem entsprechenden Behandeln der Halbleiterschicht eine erste Solarzellenstruktur, Bottomzelle, in der Halbleiterschicht erzeugt, 104 in Fig. 3. Zu diesem Zweck kann ein pn-Übergang in der Halbleiterschicht durch Dotierung erzeugt werden, beispielsweise mittels Gasphasenabscheidung oder Diffusion. Zum Erzeugen der ersten Solarzellenstruktur können zunächst ein Emitter oder sonstige Zellschichten der ersten Solarzellenstruktur je nach Zelltyp aufgebracht werden. Bei Beispielen wird eine leitfähige Rekombinationsschicht auf der texturierten Oberfläche der ersten Solarzellenstruktur erzeugt. Auf der ersten Solarzellenstruktur wird dann eine zweite Solarzellenstruktur erzeugt, 106 in Fig. 4. Das Erzeugen der zweiten Solarzellenstruktur weist bei Beispielen das Erzeugen einer Perowskitschicht zwischen einer Löchertransportschicht und einer Elektronentransportschicht auf. Bei Beispielen werden dabei gegensätzlich dotierte Schichten abgeschieden.

An dieser Stelle sei angemerkt, dass zum Erzeugen der ersten Solarzellenstruktur, Bottomzelle, und zum Erzeugen der zweiten Solarzellenstruktur, Topzelle, beliebige bekannte Verfahren verwendet werden können.

Bei der Herstellung von Solarzellen wird die Siliziumoberfläche von Wafern verändert, um effektiv Licht in elektrische Energie umzuwandeln. Dabei können monokristalline Siliziumwafer mit unterschiedlichen Ätzverfahren behandelt werden. Ein Beispiel eines Prozessflusses zum Erzeugen einer texturierten Oberfläche einer Halbleiterschicht für die Herstellung einer Tandemsolarzelle ist in Fig. 5 gezeigt. Bei Beispielen ist die Halbleiterschicht ein monokristalliner oder polykristalliner Siliziumwafer. Siliziumwafer werden typischerweise aus sogenannten Ingots gesägt. Um dabei entstehende Sägeschäden zu beseitigen und eine möglichst planare und homogene Oberfläche zu erzeugen, kann in einem vorbereitendem Ätzschritt eine Planarisierung des Wafers erfolgen, bei der die Sägeschäden des Wafers entfernt werden, Schritt 110 in Fig. 5. Dieses Ätzen erfolgt typischerweise im alkalischen Milieu, unter Verwendung von KOH bei 70 °C bis 90 °C und Behandlungszeiten unter 10 min. Dadurch können bestehende Vertiefungen, die durch das Sägen von Rohsilizium hervorgerufen sind, effektiv entfernt werden. Dabei wird der Wafer in seiner Gesamtheit gedünnt, hervorgerufen durch den Ätzabtrag, typischerweise zwischen 2 bis 6 µm pro Waferseite.

Eine dadurch bewirkte gleichmäßige Homogenität der Oberfläche bezogen auf die Glattheit und Defektarmut können den folgenden Ätzschritt 112 zum Erzeugen pyramidenförmiger Texturen begünstigen, da einheitliche Startbedingungen für das folgende Ätzmedium geschaffen werden. Im Schritt 112 findet ein alkalisches Ätzen mit einer alkalischen Ätzlösung (erste alkalische Ätzlösung) zum Ausbilden von Pyramiden statt. Die erste alkalische Ätzlösung kann dabei KOH (Kaliumhydroxid) und als Additiv Isopropanol oder ein isopropanolfreies Additiv enthalten. Dadurch wird das Silizium derart stark abgetragen, dass Pyramiden in der Oberfläche ausgebildet werden. Bei Beispielen handelt es sich bei der ersten alkalischen Ätzlösung um ein Gemisch, das langkettige Alkohole enthält, wobei die genauen Zusammensetzungen Knowhow der Hersteller sind. Ein Beispiel einer solchen Ätzlösung wird unter der deutschen Marke "Celltex" vertrieben.

Der Schritt 110 zum Entfernen von Sägeschäden kann auch entfallen, falls der Wafer bereits nach einem separaten vorherigen Waferherstellungsprozess mit einer glatten Oberfläche zur Verfügung steht. Bei Beispielen kann die erste Ätzlösung zusätzliche Additive enthalten, die es erlauben, Schritt 112 ohne die Notwendigkeit des Schritts 110 durchzuführen.

Nach der Erzeugung der pyramidenförmigen Texturen im Schritt 112 erfolgt ein alkalisches Ätzen zum Behandeln der Pyramiden, Schritt 114 in Fig. 5, was durch ein anisotropes Ätzen mit einer zweiten alkalischen Ätzlösung stattfindet und hierein als Pyramiden-Cut bezeichnet wird. Durch diesen zusätzlichen alkalischen Ätzschritt wird weiteres Silizium gezielt von den Pyramiden abgetragen, so dass die Pyramiden eine gegenüber den ursprünglichen Pyramiden geänderte Struktur und Morphologie aufweisen. Bei Beispielen kann die zweite alkalische Ätzlösung neben Wasser lediglich einen reaktiven Inhaltsstoff aufweisen. Bei dem reaktiven Inhaltsstoff kann es sich um Alkalimetallhydroxide, z. B. KOH, NaOH (Natriumhydroxid), oder TMAH (Tetramethylammoniumhydroxid) handeln.

Im Anschluss können nasschemische Reinigungsschritte erfolgen, die jedoch keine oder nur äußerst geringfügige Ätzwirkungen haben, so dass lediglich Atomlagen abgetragen werden, nicht jedoch die Pyramidenstruktur verändert wird, Schritt 116 in Fig. 5. Alternativ können auch Nachreinigungen mit stärkerer Ätzwirkung erfolgen, beispielsweise unter Verwendung von HF oder Ozon, wodurch zwar ein stärker Abtrag erfolgt, aber die durch den Pyramiden-Cut erzeugten Texturen in ihrer Struktur nicht verändert werden.

Vor und nach jedem dieser Ätzschritte können Spülschritte mit Wasser erfolgen, beispielsweise kann eine Vorreinigung vor dem Schritt 110 erfolgen und eine Vorreinigung/Hydrophilierung nach dem Schritt 110. Falls eine saure nasschemische Nachreinigung durchgeführt wird, sind solche Spülschritte zwingend notwendig, weshalb erheblich mehr Wasser für das Spülen benötigt wird. Dies wirkt sich wiederum negativ auf die Betriebskosten aus und belastet die Umwelt, da anhaftende alkalische Rückstände zu einer teilweisen Neutralisation und somit verminderter Reinigungswirkung und/oder erhöhter Säurekonzentration eines folgenden sauren Reinigungsschritts führen würden.

Nach der Nachreinigung im Schritt 116 können dann weitere Prozessschritte zur Erzeugung der Bottomzelle erfolgen, je nach Zellkonzept. Im Anschluss kann eine Abscheidung von Perowskit zum Erzeugen der oberen Solarzellenstruktur durchgeführt werden. Weitere Prozessschritte, die jeweils erforderlich sind, um die Bottomzelle (erste Solarzellenstruktur) und Topzelle (zweite Solarzellenstruktur) zu erzeugen, sind Fachleuten geläufig. Zur Reinigung können bekannte Verfahren, die als SC1, pSC1 und SC2 bekannt sind, verwendet werden. Beispielsweise kann zur Vorreinigung ein SC1-Verfahren oder ein pSC1-Verfahren verwendet werden. Zur Nachreinigung können beispielsweise folgende Verfahren verwendet werden: SC1+SC2+HF-Dip, pSC1+HF/HCl, DiO₃+HF/HCl, HF/HCl+DiO₃+HF-Dip, HF/HCl/O₃+HF/HCl.

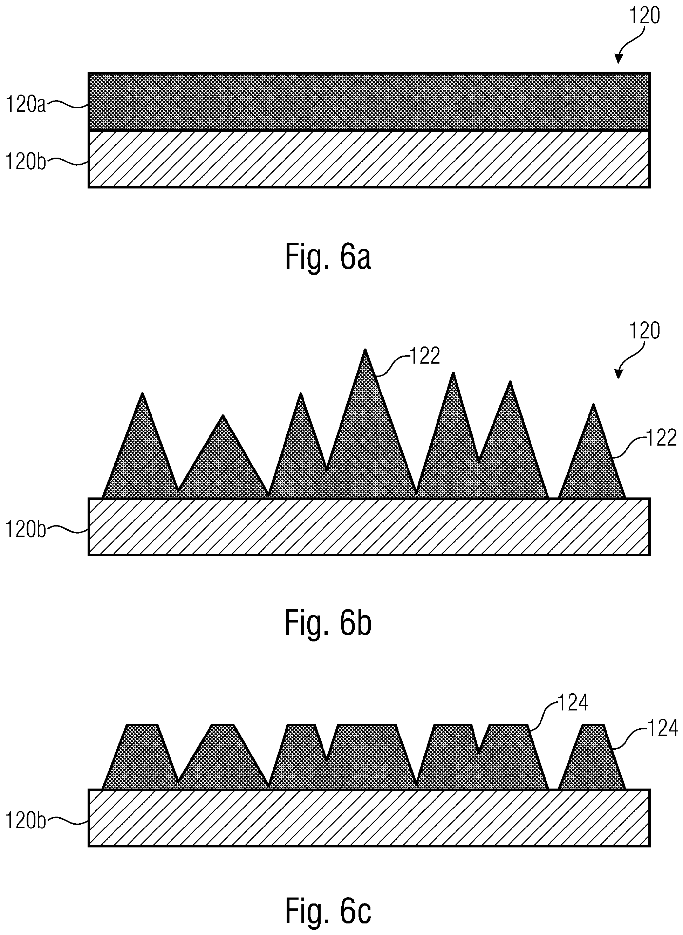

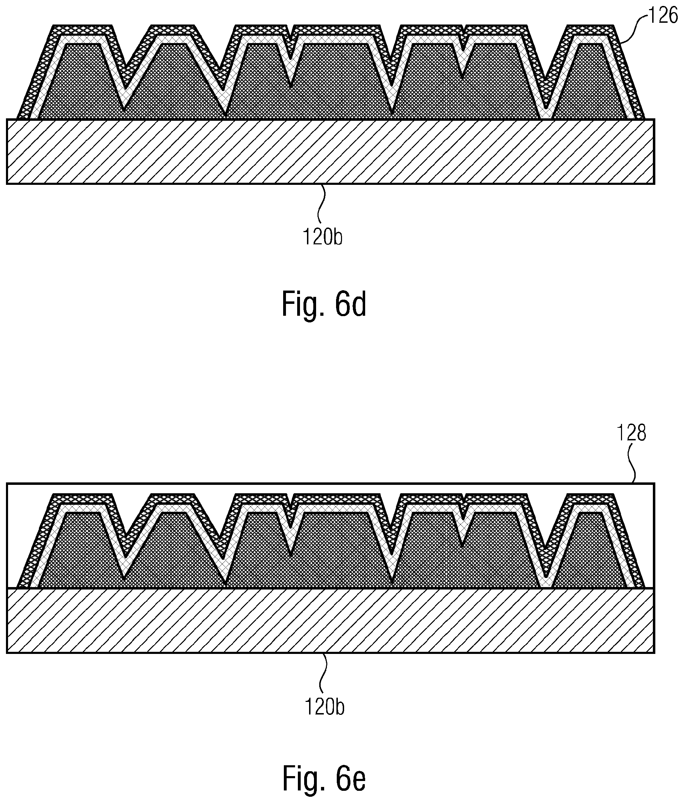

Die Fig. 6a-6e zeigen schematisch Querschnittansichten von Strukturen, die sich bei Durchführung eines Beispiels des hierin offenbarten Verfahrens ergeben. Fig. 6a zeigt eine Halbleiterschicht 120 in Form eines c-Si-Bulk-Siliziums der Bottomzelle, wobei rein zu Veranschaulichungszwecken ein Teil 120a, in dem die Texturierung erzeugt wird, separat von einem Teil 120b dargestellt ist. Fig. 6b zeigt die Halbleiterschicht 120 mit pyramidenförmigen Texturen 122 nach dem Schritt 100 in Fig. 4 bzw. 112 in Fig. 5. Dabei sei angemerkt, dass in Fig. 6b die Höhe der pyramidenförmigen Texturen 122 verglichen mit der Dicke des Teils 120a in Fig. 6a vergrößert dargestellt ist. Ausgehend von der in Fig. 6b gezeigten Struktur erfolgt das anisotrope Ätzen mit der zweiten alkalischen Ätzlösung, Schritt 102 in Fig. 4 bzw. Schritt 114 in Fig. 5. Dadurch ergeben sich abgeschnittene pyramidenförmige Strukturen 124, wie sie in Fig. 6c gezeigt sind. Obwohl in den Figuren nur eine Seite der Halbleiterschicht texturiert dargestellt ist, werden bei Beispielen durch das anisotrope Ätzen mit der zweiten alkalischen Ätzlösung entsprechende Texturen auf beiden gegenüberliegenden Hauptoberflächen der Halbleiterschicht oder allen Seiten der Halbleiterschichterzeugt. Danach können diverse Prozessschritte zum Erzeugen der ersten Solarzellenstruktur erfolgen, die sich je nach Bottomzellkonzept unterscheiden können. Lediglich beispielhaft kann eine Dotierung der Oberfläche(n), in der die Texturen erzeugt sind, erfolgen, um einen pn-Übergang zu erzeugen. Ferner kann eine Rekombinationsschicht 126, die in Fig. 6d gezeigt ist, aufgebracht werden. Im Anschluss an diese Prozessschritte wird die zweite Solarzellenstruktur auf der texturierten Seite, oder einer der beiden texturierten Seiten, rzeugt. Zu diesem Zweck erfolgt bei Beispielen eine Lösungs-basierte Abscheidung von beispielsweise Perowskit als Topzelle. Eine entsprechende Perowskitschicht 128 ist in Fig. 6e gezeigt. An dieser Stelle sei angemerkt, dass die Perowskitschicht 128 in Fig. 6e lediglich schematisch dargestellt ist, ohne irgendwelche pn-Übergänge, die bei der Erzeugung der zweiten Solarzellenstruktur erzeugt werden.

Abhängig von dem jeweiligen Solarzellenkonzept können unterschiedliche weitere Schichten zwischen der ersten Solarzellenstruktur und zweiten Solarzellenstruktur sowie auf den äußeren Oberflächen dieser Strukturen vorgesehen werden. Beispielsweise können lichtdurchlässige Elektrodenschichten, die beispielsweise Indiumzinnoxid aufweisen, auf den Oberflächen der ersten Solarzellenstruktur und der zweiten Solarzellenstruktur vorgesehen werden. Die zwischen den Solarzellenstrukturen vorgesehene Rekombinationsschicht kann beispielsweise ebenfalls Indiumzinnoxid aufweisen. Diesbezüglich ist anzumerken, dass sich die vorliegende Offenbarung insbesondere auf die Nachbehandlung der erzeugten pyramidenförmigen Texturen, den Pyramiden-Cut, bezieht, wobei bezüglich weiterer Einzelheiten von Tandemsolarzellen und Tandemsolarzellenkonzepten auf existierende Solarzellen und Solarzellenkonzepte verwiesen werden kann.

Bei dem Nachbehandlungsschritt, Schritt 102 in Fig. 4 und Schritt 114 in Fig. 5, erfolgt das Ätzen des Halbleiters, beispielsweise Silizium, anisotrop. Der Abtrag bei dem Nachbehandlungsschritt kann durch Variation von Prozessparametern eingestellt werden. Beispielsweise kann durch eine Senkung der Temperatur eine Verringerung der Reaktivität beobachtet werden. Dabei kann eine Kombination und Steuerung verschiedener Prozessparameter zu einem gleichmäßigen Ätzbild und einer gleichmäßigen Behandlung der Waferstruktur führen. Bei Beispielen können die Prozessbedingungen für den Pyramiden-Cut wie folgt definiert werden: Alkalimetallhydroxidkonzentration 0,01 bis 40 Gewichtsprozent; Temperatur: 15 bis 90 °C, bevorzugt 20 bis 80 °C, besonders bevorzugt 20 bis 65 °C; Ätzdauer: 3 bis 300 s, bevorzugt 30 bis 300 s, besonders bevorzugt 30 - 180 s; und pH-Bereich 7 bis 14, bevorzugt 9 bis 14. Es hat sich gezeigt, dass sich durch ein entsprechendes Einstellen der Prozessbedingungen ein optimiertes Zusammenspiel zwischen nötigem Abtrag für die Strukturausbildung und wirtschaftlichen Prozesszeiten erreichen lässt.

Beispielsweise kann die Ätzrate über das Einstellen der Konzentration des Ätzmediums eingestellt werden. Wird als Ätzmedium ein Alkalimetallhydroxid verwendet, so nimmt bei einer Konzentration von 0,01 bis etwa 15 Gewichtsprozent die Ätzrate mit zunehmender Konzentration zu, das heißt desto stärker wird der Pyramiden-Cut. Bei einer Konzentration von 15 bis 25 Gewichtsprozent ist die Ätzrate maximal und bei einer Konzentration über 22 Gewichtsprozent bis 40 Gewichtsprozent nimmt mit zunehmender Konzentration die Ätzrate ab, das heißt desto schwächer ist der Pyramiden-Cut. Je höher die Temperatur ist, desto höher ist die Ätzrate, das heißt desto stärker ist der Pyramiden-Cut. Je länger die Ätzdauer ist, desto höher ist der Ätzabtrag, das heißt desto stärker ist der Pyramiden-Cut. Durch Einstellen der jeweiligen Prozessbedingungen kann somit ein Materialabtrag erreicht werden, der ausreichend ist, um zu verhindern, dass Spitzen der pyramidenförmigen Texturen einen Kurzschluss bewirken.

Der Grad des Pyramiden-Cuts kann über Oberflächenreflexionsmessungen ermittelt und eingestellt werden. Der Grad des Pyramiden-Cuts kann derart eingestellt werden, dass ein Reflexionsbereich der Oberflächentextur mittels des Pyramiden-Cuts in einem Bereich von 10,0 **bis** 25,0 % bei einer Wellenlänge von 600 nm liegt. Eine andere Möglichkeit, den Materialabtrag festzustellen, besteht darin, den Pyramidenwinkel zu messen. Unter dem Pyramidenwinkel wird dabei der Winkel der Pyramidenseitenflächen zur horizontalen Substratoberfläche verstanden. Der Pyramidenwinkel der pyramidenförmigen Texturen vor dem Pyramiden-Cut beträgt ca. 55°. Durch den Pyramiden-Cut kann der Pyramidenwinkel abnehmen und in einem Bereich von 10 bis < 55°, vorzugsweise von 10 bis 50°, liegen. Einzelne Pyramiden oder Pyramidentäler können vollständig poliert werden, so dass der Winkel auch bis zu 0° betragen kann. Um den Pyramidenwinkel jeweils zu bestimmen, kann im Querschnitt der Winkel zwischen der betroffenen Seitenfläche der Pyramide und einer zur Hauptebene der Halbleiterschicht bzw. des Wafers parallelen Linie (die durch den Fußpunkt der Pyramide verläuft) bestimmt werden. Falls die Seitenfläche der Pyramide nicht gerade ist, kann sie im Querschnitt durch eine Linie, die den Fußpunkt der Seitenfläche der Pyramide mit dem höchsten Punkt der Pyramide verbindet, angenähert werden.

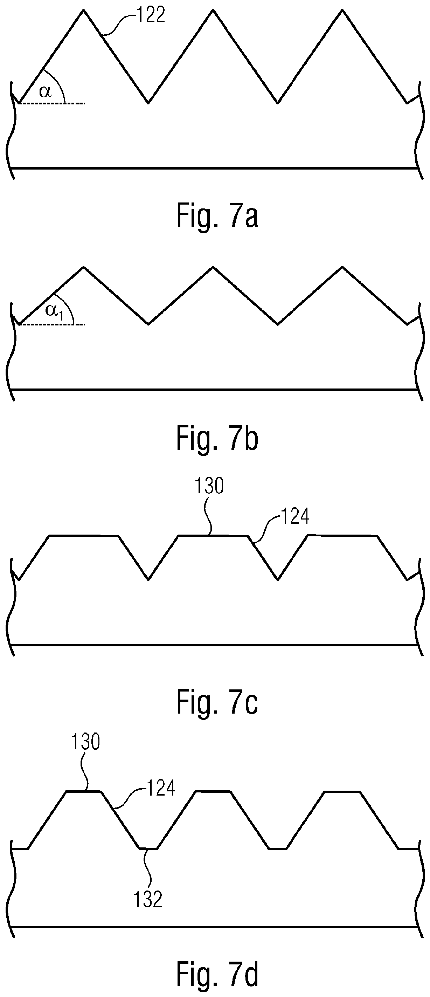

In den Fig. 7b bis 7d sind mögliche Formen der Texturen, die durch den Pyramiden-Cut erhalten werden, gezeigt. Fig. 7a zeigt die Ausgangsform nach dem Erzeugen der pyramidenförmigen Texturen durch das anisotrope Ätzen mit der ersten alkalischen Ätzlösung. Der Pyramidenwinkel α zwischen den Seitenflächen der Pyramide und der Ebene der Halbleiterschicht beträgt etwa 55°. Bei Beispielen werden durch den Pyramiden-Cut Pyramiden mit einem stumpferen Winkel α₁ von < 55° oder < 50°erzeugt, wie in Fig. 7b gezeigt ist. Wie in Fig. 7c gezeigt ist, werden bei Beispielen durch den Pyramiden-Cut Texturen mit abgetragenen Pyramidenspitzen erzeugt, das heißt Texturen 124, die ein Plateau 130 aufweisen, das durch den Abtrag von Spitzen der pyramidenförmigen Texturen 122 gebildet ist. Die Plateaus 130 können im Wesentlichen parallel zu der Substratebene angeordnet sein. Der Pyramidenwinkel kann dabei ≤ 55° sein. Bei Beispielen können durch den Pyramiden-Cut neben den abgetragenen Pyramidenspitzen auch Plateaus 132 in Tälern zwischen Pyramidenspitzen erzeugt werden, bei einem Pyramidenwinkel ≤ 55°, Fig. 7d. Dabei ist anzumerken, dass die Plateaus 132 nicht durch Auffüllen der Täler erzeugt werden, sondern durch einen erhöhten anisotropen Gesamtabtrag.

Die erste Ätzlösung enthält ein Additiv, durch das aufgrund der unterschiedlichen Ätzraten der Kristallebenen pyramidenförmige Texturen, wie sie in Fig. 7a gezeigt sind, erzeugt werden. Die zweite alkalische Ätzlösung enthält ein solches Additiv nicht, so dass die Ätzraten der Kristallebenen, die im vorherigen Schritt durch das Additive beeinflusst wurden, direkt und ausschließlich der zweiten alkalischen Ätzlösung (und vorhandenen Reaktionsprodukten wie z.B. Silikat) beim Ätzen ausgesetzt sind. Dadurch kann ein Materialabtrag der existierenden pyramidenförmigen Texturen stattfinden, durch den sich die Form, Struktur und Morphologie der pyramidenförmigen Texturen ändert. Dabei können die in den Fig. 7b bis 7d gezeigten Formen auch parallel und/oder als Mischform vorliegen. In jedem Fall wird durch den Pyramiden-Cut die Höhe der pyramidenförmigen Texturen reduziert, um zu ermöglichen, dass nachfolgend Material der zweiten Solarzellenstruktur, beispielsweise Perowskit, durch Lösungs-basierte Verfahren aufgebracht werden kann, ohne die Gefahr von Kurzschlüssen. Bei Beispielen kann die Reduzierung der Höhendifferenz zwischen Gipfeln und benachbarten Tälern mindestens 5 %, mindestens 10 % oder mindestens 20 % betragen, um dies zu erreichen. Eine entsprechende Reduzierung der Höhe kann durch einen Vergleich der Texturen vor und nach dem Pyramiden-Cut ermittelt werden oder durch einen Vergleich der Texturen nach dem Pyramiden-Cut mit einer vollständigen Pyramide mit eine Pyramidenwinkel von 55°. Anders ausgedrückt entspricht eine entsprechende Reduzierung einer entsprechenden Differenz zu einer vollständigen Pyramide mit einem Pyramidenwinkel, wie er sich durch das Ätzen mit der ersten Ätzlösung ergibt, z.B. 55°. Es bedarf keiner separaten Erläuterung, dass die Größen und Formen der pyramidenförmigen Texturen und der dem Pyramiden-Cut unterzogenen Texturen ohne Weiteres beispielsweise anhand von Bildaufnahmen von durchgeschnittenen Tandemsolarzellen, durch Vermessen der Oberfläche der texturierten Oberfläche oder durch gravimetrische Analysen verifiziert werden können.

Durch das anisotrope Ätzen mit der zweiten alkalischen Ätzlösung wird ein Materialabtrag bewirkt, der zu einer Veränderung der Pyramidenstruktur führt. Bei Beispielen führen die gebildeten Plateaus zu veränderten optischen Eigenschaften, insbesondere zu einem messbaren und merklichen Anstieg des Reflexionsgrads, d.h. der Reflektivität. Die Reflektivität kann mit diversen optischen Messgeräten wie einem Spektralphotometer ermittelt werden. Für eine analytische Vergleichbarkeit wird typischerweise der Unterschied der Reflektivität bei einer festen Wellenlänge, wie z.B. bei 600 nm, verwendet. Bei Beispielen kann durch das anisotrope Ätzen mit der zweiten alkalischen Ätzlösung eine Erhöhung (absolut) der Reflektivität für Licht einer Wellenlänge von 600 nm von mindestens 0,5% bis 10%, bevorzugt von 1% bis 8%, besonders bevorzugt von 2% bis 6% bewirkt werden. Die Reflektivität kann durch Oberflächenreflexionsmessungen ermittelt werden, die sich auf alle Anteile des reflektierten Lichts beziehen, welche sich aus diffuser Reflexion und direkter Reflexion zusammensetzen. Beispielsweise kann die Reflektivität unter Verwendung eines Kugelspektralphotometers mit der Bezeichnung X-Rite^{®} Ci62 in einem Messmodus SPIN (specular included) gemessen werden.

Bei Beispielen ist die zweite alkalische Ätzlösung eine KOH-Lösung mit einer KOH-Konzentration von weniger als 5%. Es hat sich herausgestellt, dass ein entsprechender Materialabtrag bei dem Pyramiden-Cut durch die Verwendung einer solchen Ätzlösung erreicht werden kann, wobei die dadurch bedingte verringerte Ätzrate durch eine Erhöhung der Temperatur und/oder der Ätzzeit ausgeglichen werden kann.

Bei Beispielen kann das Verfahren während des Ätzens mit der zweiten Ätzlösung das Anwenden von Ultraschall auf die zweite Ätzlösung aufweisen. Zu diesem Zweck kann ein entsprechender Ultraschallwandler vorgesehen sein. Durch die Verwendung von Ultraschall kann die Ätzrate während des Pyramiden-Cuts erhöht werden, können Wasserstoffbläschen zerstört werden und kann eine homogenere Ätzung bezogen auf die Fläche erreicht werden. Die Verwendung von Ultraschall zur Unterstützung von alkalischen Ätzprozessen ist beispielsweise aus der US 6 224 713 B1 bekannt.

Durch die Erfindung ist es somit möglich, Tandemsolarzellen herzustellen, bei welchen sowohl die Bottomzelle eine Textur aufweist als auch der folgende Abscheideprozess beispielsweise des Perowskits mittels Lösungs-basierten Verfahren durchgeführt wird, ohne dass Spitzen der pyramidenförmigen Texturen aus der abgeschiedenen Perowskit-Schicht ragen. Beispiele ermöglichen somit Lösungs-basierte Abscheideverfahren von beispielsweise Perowskiten auf eine c-Si-Solarzelle mit texturierter Oberfläche und die damit verbundene Lösung von Kurzschluss-Problemen durch die Pyramidenspitzen. Dadurch ist eine Steigerung der Energieausbeute der Tandemsolarzelle zu erwarten. Die vorliegende Erfindung ermöglicht dies durch den beschriebenen Pyramiden-Cut, der ein an den Texturprozess anschließender und mit dem Texturprozess gekoppelter Prozessschritt ist, bei welchem die Oberflächenmorphologie, die im Texturprozess erzeugt wird, dahin gehend verändert wird, dass die erzeugten Pyramiden entweder abstumpfen, die Pyramidenspitzen abgeschnitten werden und/oder sich Plateaus sowohl in den Tälern als auch auf den Pyramiden bilden. Durch die morphologische Änderung der ursprünglichen Textur mittels des Pyramiden-Cuts ist es möglich, die nächste Solarzellenschicht, beispielsweise Perowskit, mittels Lösungs-basierter Abscheideverfahren aufzubringen. Dies ist möglich, da die veränderten Pyramiden, speziell die Pyramidenspitzen, nicht mehr durch die abgeschiedene Solarzellenschicht, beispielsweise das Peroswkit, ragen und somit keine elektrischen Kurzschlüsse verursachen.

Bekannte Verfahren zum Behandeln von Texturen sind bei J. Du u.a., "Selective rounding for pyramid peaks and valleys improves the performance of SHJ solar cells", Energy Sci Eng. 2021, 00, 1- 7, und L. Mohr u.a., "Numerical Simulation of an Ozone-Based Wet-Chemical Etching", Industrial & Engineering Chemistry Research, 2020, 59 (40), 17680-17688), beschrieben. Im Gegensatz zu solchen bekannten Verfahren, bei denen eine Behandlung (Abtrag) zur Pyramidenverrundung mittels HF und ozonisiertem Wasser erfolgt, wird dies bei Beispielen der Erfindung mit nicht toxischen Ätzmitteln ermöglicht, was die Umwelt schont, wobei weniger Reinigungsflüssigkeiten bzw. Reinigungsschritte benötigt werden, was die Betriebskosten senkt. Erfindungsgemäß wird ein anisotroper Ätzmechanismus verwendet, während der Wirkmechanismus bekannter Lösungen unterschiedlich ist, wo Ozon oder Salpetersäure durch Ausbildung von Siliziumdioxid oxidierend gegenüber Silizium wirken, woraufhin ein Abtrag durch Ätzen von Siliziumdioxid mittels Flusssäure stattfindet, was einen isotropen Ätzmechanismus darstellt und als chemisches Polieren beschrieben wird. Bei dem bekannten Verfahren findet eine Verrundung der Spitzen mit einem gegebenen Krümmungsradius statt, ohne einen merklichen Abtrag im Vergleich zur Gesamthöhe. Im Gegensatz dazu werden durch das erfindungsgemäße Verfahren abweichende Strukturen erzeugt, insbesondere auch Plateaus, wie sie bezugnehmend auf die Fig. 7c und 7d beschrieben wurden. Erfindungsgemäß wird eine zweite alkalische Ätzlösung für den Pyramiden-Cut verwendet, was eine Ätzrate > 50 nm/min ermöglicht. Im Gegensatz dazu liegen bei einer Ozonkonzentration von 15, 30 oder 40 mg/l Ätzraten bei dem bekannten sauren Ätzen in einem Bereich von 5, 9 oder 11 nm/min. Bei bekannten Verfahren, die HNO₃ und HF verwenden, wird poröses Silizium gebildet, welches in einem zusätzlichen KOH-Schritt entfernt werden muss. Dies ist bei der erfindungsgemäßen Vorgehensweise nicht notwendig. Als besonders nachteilig an dem bekannten Verfahren wird dabei die Umweltbelastung durch die beiden toxischen Bestandteile gesehen. Ferner werden hier im Gegensatz zur vorliegenden Offenbarung, bei der der Pyramiden-Cut mittels einer alkalischen Ätzlösung bewirkt wird, neben Wasser zwei aktive Inhaltsstoffe benötigt. Der Abtrag mit Flusssäure und Ozon ist sehr viel schwächer ausgeprägt und hat eine signifikante mikroskopische Verrundung nur der Spitzen zufolge, jedoch ohne Veränderung des Winkels ohne eine merkliche Reduktion der Höhe. Typische Abträge beziffern sich hier auf 47,7 nm in 10 min (80 ppm Ozon, 0,08 % HF, 20 °C). Diese Prozesszeiten sind für eine industrielle Anwendung nicht wirtschaftlich, da keine hohen Durchsätze bei der Solarzellenproduktion erreicht werden können. Zudem werden zusätzliche Produktionsmittel zur Erzeugung von Ozon benötigt, wobei die Kosten zur Erzeugung solcher Mengen an Ozon enorm sind, wobei darüber hinaus ozonbeständige Materialien kostenintensiv sind. Das chemische Polieren kann ebenfalls durch eine Mischung aus Salpetersäure und Flusssäure erreicht werden. Hier sind ebenfalls zwingendermaßen zwei reaktive Inhaltsstoffe erforderlich, die beide als toxisch eingestuft sind, wobei die stark exotherme Reaktion Stickoxide als Reaktionsprodukt generiert und zu umweltschädlichen nitrathaltigen Abwässern führt, verbunden mit einem erhöhten Aufbereitungsaufwand und Kosten. Die erfindungsgemäße Vorgehensweise ermöglicht somit gegenüber solchen bekannten Verfahren eine zeitsparende, weniger aufwändige und umweltschonendere Möglichkeit, pyramidenförmige Texturen mit veränderter Morphologie zu erzeugen und somit Kurzschlüsse in Tandemsolarzellen zu verhindern.

Die vorliegende Erfindung ist auf viele verschiedenen Anwendungsgebiete anwendbar, beispielsweise alle c-Si-basierten Solarzellkonzepte, wie z.B. HJT (heterojunction), PERC (Zelle mit passivierter Emissionselektrode und Rückseite), TOPCON (Tunneloxid-passivierte Träger-selektive Kontakte) usw., auf welche jede für ein Tandemsolarzellkonzept geeignete Solarzellschicht abgeschieden werden kann.

Beispiele der vorliegenden Offenbarung beziehen sich insbesondere auf die Erzeugung einer texturierten Oberfläche einer Halbleiterschicht, wobei sich der erfindungsgemäße Schritt des Pyramiden-Cuts dabei von üblichen Nachreinigungsverfahren unterscheidet, wie sie bei üblichen Verfahren nach jedem chemischen Behandlungsschritt durchgeführt werden. Beispielsweise werden die Waferoberflächen nach jedem chemischen Behandlungsschritt mit deionisiertem Wasser gereinigt. Weitere Verunreinigungen wie metallische Verunreinigungen können mit Mischungen aus Wasser, Salzsäure und/oder Flusssäure effektiv entfernt werden. Den Mischungen kann auch Ozon zugeführt werden, da Ozon ein hohes Oxidationspotenzial aufweist. Organische Verunreinigungen können bevorzugt mit Mischungen aus Wasserstoffperoxid und/oder alkalischen Medien, wie z.B. Ammoniak, Hypochlorit-Lösungenoder Ozon entfernt werden. Ozon besitzt eine geringe Beständigkeit in einer alkalischen Umgebung, wobei dem Ozon bevorzugt eine Säure zugeführt wird, besonderes bevorzugt Salzsäure (HCl) und/oder Flusssäure (HF). Durch den Zusatz von Säure zu ozonisiertem Wasser kann ebenfalls eine Reinigung gegenüber metallischen Verunreinigungen erzielt werden. Solche Reinigungsverfahren haben jedoch keinen ausreichenden Ätzabtrag, um die pyramidenartige Struktur des Siliziumwafers zu verändern

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen. Folglich werden die folgenden Ansprüche hiermit in die detaillierte Beschreibung aufgenommen, wobei jeder Anspruch als ein eigenes separates Beispiel stehen kann. Während jeder Anspruch als ein eigenes separates Beispiel stehen kann, sei angemerkt, dass, obwohl sich abhängige Ansprüche in den Ansprüchen auf eine spezifische Kombination mit einem oder mehreren anderen Ansprüchen zurückbeziehen, andere Beispiele auch eine Kombination von abhängigen Ansprüchen mit dem Gegenstand jedes anderen abhängigen Anspruchs oder einer Kombination jedes Merkmals mit anderen abhängigen oder unabhängigen Ansprüchen umfassen. Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist.

Die oben beschriebenen Beispiele sind nur darstellend für die Grundsätze der vorliegenden Offenbarung. Es ist zu verstehen, dass Modifikationen und Variationen der Anordnungen und der Einzelheiten, die beschrieben sind, für Fachleute offensichtlich sind. Es ist daher beabsichtigt, dass die Erfindung nur durch die beigefügten Patentansprüche und nicht durch die spezifischen Einzelheiten, die zum Zwecke der Beschreibung und Erklärung der Beispiele dargelegt sind, begrenzt ist.

## Patentansprüche

1. Verfahren zum Erzeugen einer texturierten Oberfläche einer Halbleiterschicht, mit folgenden Merkmalen:
anisotropes Ätzen einer Oberfläche einer Halbleiterschicht mit einer ersten alkalischen Ätzlösung, um eine Oberfläche der Halbleiterschicht, die pyramidenförmige Texturen aufweist, zu erzeugen; und
anisotropes Ätzen der Oberfläche, die die pyramidenförmigen Texturen aufweist, mit einer zweiten alkalischen Ätzlösung, die von der ersten alkalischen Ätzlösung verschieden ist und kein Additiv, das die Erzeugung pyramidenförmiger Strukturen bewirkt, aufweist, um einen Materialabtrag der pyramidenförmigen Texturen zu bewirken, durch den eine Höhendifferenz zwischen Gipfeln und benachbarten Tälern der pyramidenförmigen Texturen reduziert wird,
wobei durch das anisotrope Ätzen mit der zweiten alkalischen Ätzlösung die Höhendifferenz zwischen Gipfeln und benachbarten Tälern von zumindest einigen der pyramidenförmigen Texturen um mindestens 5%, bevorzugt um mindestens 10% reduziert wird.

2. Verfahren nach Anspruch 1, bei dem durch das anisotrope Ätzen mit der zweiten alkalischen Ätzlösung die Reflektivität der Oberfläche der Halbleiterschicht, die die Texturen aufweist, für Licht einer Wellenlänge von 600 nm um absolut 0,5% bis 10% erhöht, bevorzugt um absolut 1% bis 8% erhöht, besonders bevorzugt um absolut 2% bis 6% erhöht.

3. Verfahren nach Anspruch 1 oder 2, bei dem durch das Ätzen mit der zweiten Ätzlösung ein Winkel zwischen Pyramidenflächen von zumindest einigen der pyramidenförmigen Texturen und einer Ebene der Halbleiterschicht reduziert wird, und/oder Pyramidenspitzen von zumindest einigen der pyramidenförmigen Texturen abgetragen werden.

4. Verfahren nach einem der Ansprüche 1 bis 3, bei dem ein Reflexionsgrad der texturierten Oberfläche nach dem Ätzen mit der zweiten Ätzlösung 10 bis 25 % für Licht einer Welle von 600 nm beträgt.

5. Verfahren nach einem der Ansprüche 1 bis 4, bei dem die zweite alkalische Ätzlösung eine Alkalimetalllösung, eine Erdalkalimetalllösung oder eine TMAH-Ätzlösung ist.

6. Verfahren nach einem der Ansprüche 1 bis 5, bei dem die Halbleiterschicht kristallines Silizium aufweist.

7. Verfahren nach einem der Ansprüche 1 bis 6, bei dem das anisotrope Ätzen der Oberfläche, die die pyramidenförmigen Texturen aufweist, unter zumindest einer der folgenden Prozessbedingungen durchgeführt wird:
Alkalimetallhydroxidkonzentration: 0,01 - 40 Gewichtsprozent,
Temperatur: 15 - 90 °C, bevorzugt 20 - 80°C, besonders bevorzugt 20 - 65 °C
Ätzdauer: 3 - 300 s, bevorzugt 30 - 300 s, besonders bevorzugt 30 - 180 s;
pH-Bereich: 7 - 14, bevorzugt 9 - 14.

8. Verfahren nach einem der Ansprüche 1 bis 7, das vor dem anisotropen Ätzen mit der ersten Ätzlösung ein alkalisches Ätzen mit einem dritten Ätzmittel zum Entfernen von Sägeschäden von der Halbleiterschicht aufweist, und/oder das nach dem Ätzen mit der zweiten Ätzlösung eine nasschemische Reinigung der texturierten Oberfläche aufweist.

9. Verfahren nach einem der Ansprüche 1 bis 8, das ferner ein Einstellen des durch das Ätzen mit der zweiten Ätzlösung bewirkten Abtrags aufweist, durch zumindest entweder
Einstellen einer Kaliumhydroxid-Konzentration in der zweiten Ätzlösung, wobei bei einer Hydroxid-Konzentration bis 15 Gewichtsprozent die Ätzrate mit zunehmender Hydroxid-Konzentration zunimmt, von 15 bis 20 Gewichtsprozent die Ätzrate ein Maximum aufweist und bei einer Hydroxid-Konzentration über 25 Gewichtsprozent die Ätzrate mit zunehmender Hydroxid-Konzentration abnimmt,
Einstellen der Temperatur, wobei mit steigender Temperatur die Ätzrate zunimmt, oder
Einstellen der Ätzdauer, wobei mit steigender Ätzdauer der Gesamtätzabtrag zunimmt.

10. Verfahren nach einem der Ansprüche 1 bis 9, das ein Anwenden von Ultraschall auf die zweite Ätzlösung während des Ätzens mit der zweiten Ätzlösung aufweist.

11. Verfahren zum Herstellen einer Tandemsolarzelle, mit folgenden Merkmalen:
Durchführen eines Verfahrens nach einem der Ansprüche 1 bis 10;
Erzeugen einer ersten Solarzellenstruktur der Tandemsolarzelle, die die texturierte Oberfläche aufweist; und
Erzeugen einer zweiten Solarzellenstruktur der Tandemsolarzelle auf der Seite der ersten Solarzellenstruktur, auf der die texturierte Oberfläche angeordnet ist.

12. Verfahren nach Anspruch 11, bei dem das Erzeugen der ersten Solarzellenstruktur das Erzeugen eines pn-Übergangs in oder auf der Halbleiterschicht aufweist, bei dem das Erzeugen der zweiten Solarzellenstruktur das Erzeugen eines pn-Übergangs aufweist, wobei zwischen der ersten und der zweiten Solarzellenstruktur eine leitfähige Schicht, eine elektrische Kontaktierung und/oder ein elektrische Isolierung erzeugt wird.

13. Verfahren nach einem der Ansprüche einem der Ansprüche 11 oder 12, bei dem die zweite Solarzellenstruktur eine Perowskit-Schicht aufweist, wobei das Verfahren vorzugsweise ein Aufbringen der Perowskit-Schicht mittels einem zumindest teilweise Lösungs-basierten Verfahren aufweist.

14. Tandemsolarzelle mit folgenden Merkmalen:
einer ersten Solarzellenstruktur, die eine Halbleiterschicht mit einer texturierten Oberfläche, die nach einem Verfahren nach einem der Ansprüche 1 bis 10 erzeugt ist, aufweist; und
einer zweiten Solarzellenstruktur auf der Seite der ersten Solarzellenstruktur, auf der die texturierte Oberfläche angeordnet ist,
wobei die texturierte Oberfläche der Halbleiterschicht Texturen aufweist, die ein Plateau aufweisen, das durch den Abtrag von Spitzen der pyramidenförmigen Texturen gebildet ist, so dass eine Höhendifferenz zwischen Gipfeln und benachbarten Tälern der pyramidenförmigen Texturen verglichen mit entsprechenden Texturen ohne abgetragene Spitzen um mindestens 5%, bevorzugt um mindestens 10% reduziert ist, und/oder Texturen aufweist, bei denen ein Winkel zwischen einer Pyramidenfläche von zumindest einigen der pyramidenförmigen Texturen und einer Ebene der Halbleiterschicht 50° oder weniger beträgt, so dass die Höhendifferenz zwischen Gipfeln und benachbarten Tälern der pyramidenförmigen Texturen verglichen mit entsprechenden Texturen, bei denen ein Winkel zwischen einer Pyramidenfläche und einer Ebene der Halbleiterschicht etwa 55° beträgt, um mindestens 5%, bevorzugt um mindestens 10% reduziert ist.

15. Tandemsolarzelle nach Anspruch 14, bei der ein Reflexionsgrad der texturierten Oberfläche der Halbleiterschicht 10 bis 25 % für Licht einer Wellenlänge von 600 nm beträgt.

## Claims

1. Method for generating a textured surface of a semiconductor layer, comprising:
anisotropic etching of a surface of a semiconductor layer with a first alkaline etching solution to generate a surface of the semiconductor layer comprising pyramid-shaped textures; and
anisotropic etching of the surface comprising the pyramid-shaped textures with a second alkaline etching solution, which differs from the first alkaline etching solution and does not comprise any additive causing the generation of pyramid-shaped structures, to cause material removal of the pyramid-shaped textures, thereby reducing a height difference between peaks and neighboring valleys of the pyramid-shaped textures.
wherein, by anisotropic etching with the second alkaline etching solution, the height difference between peaks and neighboring valleys of at least some of the pyramid-shaped textures is reduced by at least 5%, preferably by at least 10%.

2. Method according to claim 1, wherein, by anisotropic etching with the second alkaline etching solution, the reflectivity of the surface of the semiconductor layer comprising the textures is increased for light of a wavelength of 600 nm by 0.5% to 10% in absolute terms, preferably by 1% to 8% in absolute terms, particularly preferably by 2% to 6% in absolute terms.

3. Method according to claim 1 or 2, wherein, by etching with the second etching solution, an angle between pyramid faces of at least some of the pyramid-shaped textures and a plane of the semiconductor layer is reduced, and/or pyramid tips of at least some of the pyramid-shaped textures are removed.

4. Method according to any one of claims 1 to 3, wherein, after etching with the second etching solution, a degree of reflection of the textured surface is 10% to 25% for light of a wave of 600 nm.

5. Method according to any one of claims 1 to 4, wherein the second alkaline etching solution is an alkali metal solution, an alkaline earth metal solution or a TMAH etching solution.

6. Method according to any one of claims 1 to 5, wherein the semiconductor layer comprises crystalline silicon.

7. Method according to any one of claims 1 to 6, wherein anisotropic etching of the surface comprising the pyramid-shaped textures is carried out under at least one of the following process conditions:
alkali metal hydroxide concentration: 0.01 - 40 percent by weight,
temperature: 15 - 90°c, preferably 20 - 80°C, particularly preferably 20 - 65°c
etching duration: 3 - 300 s, preferably 30 - 300 s, particularly preferably 30 - 180 s;
pH range: 7 - 14, preferably 9 - 14.

8. Method according to any one of claims 1 to 7, comprising, prior to anisotropic etching with the first etching solution, alkaline etching with a third etching medium for removing sawing damage from the semiconductor layer and/or comprising, after etching with the second etching solution, wet-chemical cleaning of the textured surface.

9. Method according to any one of claims 1 to 8, further comprising adjusting the removal caused by etching with the second etching solution by at least one of:
adjusting a potassium hydroxide concentration in the second etching solution, wherein, at a hydroxide concentration of up to 15 percent by weight, the etching rate increases with increasing hydroxide concentration, from 15 to 20 percent by weight, the etching rate is at its maximum, and, at a hydroxide concentration above 25 percent by weight, the etching rate decreases with increasing hydroxide concentration,
adjusting the temperature, wherein the etching rate increases as the temperature rises, or
adjusting the etching duration, wherein the total etching removal increases with increasing etching duration.

10. Method according to any one of claims 1 to 9, comprising applying ultrasound to the second etching solution during etching with the second etching solution.

11. Method for manufacturing a tandem solar cell, comprising:
performing a method according to any one of claims 1 to 10;
generating a first solar cell structure of the tandem solar cell comprising the textured surface; and
generating a second solar cell structure of the tandem solar cell on the side of the first solar cell structure on which the textured surface is arranged.

12. Method according to claim 11, wherein generating the first solar cell structure comprises generating a pn-junction in or on the semiconductor layer, wherein generating the second solar cell structure comprises generating a pn-junction, wherein a conductive layer, an electrical contact, and/or an electrical insulation is generated between the first and the second solar cell structure.

13. Method according to any one of claims any one of claims 11 to 12, wherein the second solar cell structure comprises a perovskite layer, the method preferably comprising depositing the perovskite layer by means of an at least partially solution-based method.

14. Tandem solar cell, comprising:
a first solar cell structure comprising a semiconductor layer with a textured surface, generated according to a method according to any one of claims 1 to 10; and
a second solar cell structure on the side of the first solar cell structure on which the textured surface is arranged,
wherein the textured surface of the semiconductor layer comprises textures comprising a plateau formed by the removal of tips of the pyramid-shaped textures so that a height difference between peaks and neighboring valleys of the pyramid-shaped texture is reduced by at least 5%, preferably by at least 10%, compared to corresponding textures without removed tips, and/or comprises textures in which an angle between a pyramid face of at least some of the pyramid-shaped textures and a plane of the semiconductor layer is 50° or less so that the height difference between peaks and neighboring valleys of the pyramid-shaped textures is reduced by at least 5%, preferably by at least 10%, compared to corresponding textures in which an angle between a pyramid face and a plane of the semiconductor layer is approximately 55°.

15. Tandem solar cell according to claim 14, wherein a degree of reflection of the textured surface of the semiconductor layer is 10 to 25% for light of a wavelength of 600 nm.

## Revendications

1. Procédé destiné à produire une surface texturée d'une couche semi-conductrice, avec les caractéristiques suivantes :
réaliser une gravure anisotrope d'une surface d'une couche semi-conductrice avec une première solution de gravure alcaline pour produire une surface de la couche semi-conductrice qui présente des textures pyramidales ; et
réaliser une gravure anisotrope de la surface qui présente les textures pyramidales avec une deuxième solution de gravure alcaline qui est différente de la première solution de gravure alcaline et ne présente aucun additif qui provoque la production de structures pyramidales pour provoquer un enlèvement de matière des textures pyramidales, ce qui permet de réduire une différence de hauteur entre des pics et des vallées adjacentes des textures pyramidales,
dans lequel la gravure anisotrope avec la deuxième solution de gravure alcaline permet de réduire la différence de hauteur entre des pics et des vallées adjacentes d'au moins quelques-unes des textures pyramidales d'au moins 5 %, de préférence d'au moins 10 %.

2. Procédé selon la revendication 1, dans lequel la gravure anisotrope avec la deuxième solution de gravure alcaline permet d'augmenter absolument de 0,5 % à 10 %, de préférence absolument de 1 % à 8 %, de manière particulièrement préférée absolument de 2 % à 6 %, la réflectivité de la surface de la couche semi-conductrice qui présente les textures pour la lumière d'une longueur d'onde de 600 nm.

3. Procédé selon la revendication 1 ou 2, dans lequel la gravure avec la deuxième solution de gravure permet de réduire un angle entre des surfaces pyramidales d'au moins quelques-unes des textures pyramidales et un plan de la couche semi-conductrice et/ou d'enlever des sommets pyramidaux d'au moins quelques-unes des textures pyramidales.

4. Procédé selon une des revendications 1 à 3, dans lequel un degré de réflexion de la surface texturée après la gravure avec la deuxième solution de gravure représente 10 à 25 % pour la lumière d'une onde de 600 nm.

5. Procédé selon une des revendications 1 à 4, dans lequel la deuxième solution de gravure alcaline est une solution de métal alcalin, une solution de métal alcalino-terreux ou une solution de gravure TMAH.

6. Procédé selon une des revendications 1 à 5, dans lequel la couche semi-conductrice présente du silicium cristallin.

7. Procédé selon une des revendications 1 à 6, dans lequel la gravure anisotrope de la surface qui présente les textures pyramidales est mise en œuvre dans au moins une des conditions de processus suivantes :
Concentration d'hydroxyde de métal alcalin : 0,01 à 40 pour cent en poids,
Température : 15 à 90 °C, de préférence 20 à 80°C, particulièrement préférablement 20 à 65 °C,
Temps de gravure : 3 à 300 s, de préférence 30 à 300 s, particulièrement préférablement 30 à 180 s,
plage pH : 7 à 14, de préférence 9 à 14.

8. Procédé selon une des revendications 1 à 7, qui présente, avant la gravure anisotrope avec la première solution de gravure, une gravure alcaline avec un troisième agent de gravure pour éliminer les dommages de sciage de la couche semi-conductrice, et/ou qui présente, après la gravure avec la deuxième solution de gravure, un nettoyage chimique humide de la surface texturée.

9. Procédé selon une des revendications 1 à 8, qui présente en outre un ajustement de l'enlèvement provoqué par la gravure avec la deuxième solution de gravure soit au moins par une étape destinée à
ajuster une concentration d'hydroxyde de potassium dans la deuxième solution de gravure, dans lequel à une concentration d'hydroxyde allant jusqu'à 15 pour cent en poids la vitesse de gravure augmente avec l'augmentation de la concentration d'hydroxyde, de 15 à 20 pour cent en poids la vitesse de gravure présente un maximum et, à une concentration d'hydroxyde supérieure à 25 pour cent en poids, la vitesse de gravure diminue avec l'augmentation de la concentration d'hydroxyde,
ajuster la température, où avec une température croissante la vitesse de gravure augmente, ou
ajuster le temps de gravure, où avec un temps de gravure croissant l'enlèvement total de gravure augmente.

10. Procédé selon une des revendications 1 à 9, qui présente l'application d'ultrasons à la deuxième solution de gravure pendant la gravure avec la deuxième solution de gravure.

11. Procédé destiné à fabriquer une cellule solaire en tandem, avec les caractéristiques suivantes :
mettre en œuvre un procédé selon une des revendications 1 à 10 ;
produire une première structure de cellules solaires de la cellule solaire en tandem qui présente la surface texturée ; et
produire une seconde structure de cellules solaires de la cellule solaire en tandem sur le côté de la première structure de cellules solaires sur lequel la surface texturée est disposée.

12. Procédé selon la revendication 11, dans lequel la production de la première structure de cellules solaires présente la production d'une jonction pn dans ou sur la couche semi-conductrice, dans lequel la production de la deuxième structure de cellules solaires présente la production d'une jonction pn, dans lequel, entre la première et la seconde structure de cellules solaires, est produite une couche conductrice, un contact électrique et/ou une isolation électrique.

13. Procédé selon une des revendications une des revendications 11 ou 12, dans lequel la deuxième structure de cellules solaires présente une couche de pérovskite, dans lequel le procédé présente de préférence une application de la couche de pérovskite au moyen d'un procédé basé au moins partiellement sur la solution.

14. Cellule solaire en tandem avec les caractéristiques suivantes :
une première structure de cellules solaires qui présente une couche semi-conductrice avec une surface texturée, qui est produite selon un procédé selon une des revendications 1 à 10 ; et
une seconde structure de cellules solaires sur le côté de la première structure de cellules solaires sur lequel est disposée la surface texturée,
dans lequel la surface texturée de la couche semi-conductrice présente des textures qui présentent un plateau qui est formé par l'enlèvement de sommets des textures pyramidales de sorte qu'une différence de hauteur entre des pics et des vallées adjacentes des textures pyramidales soit réduite d'au moins 5 %, de préférence d'au moins 10 %, par rapport à des textures correspondantes sans les sommets enlevés et/ou présente des textures où un angle entre une surface pyramidale d'au moins quelques-unes des textures pyramidales et un plan de la couche semi-conductrice est inférieur ou égal à 50° de sorte que la différence de hauteur entre des pics et des vallées adjacentes des textures pyramidales soit réduite d'au moins 5 %, de préférence d'au moins 10 %, par rapport à des textures correspondantes où un angle entre une surface pyramidale et un plan de la couche semi-conductrice est d'environ 55°.

15. Cellule solaire en tandem selon la revendication 14, dans laquelle un degré de réflexion de la surface texturée de la couche semi-conductrice représente 10 à 25 % pour la lumière d'une longueur d'onde de 600 nm.
